# EUROPÄISCHE PATENTANMELDUNG

(11) **EP 2 317 832 A2**
(43) Veröffentlichungstag der Anmeldung: **04.05.2011**
(21) Anmeldenummer: 10014070.6
(22) Anmeldetag: 28.10.2010
(51) Int. Cl.: H05K 5/00

(54) **Gehäuse**

(30) Priorität: 03.11.2009 DE 202009014800 U
(71) Anmelder: Rose Systemtechnik GmbH, 32457 Porta Westfalica (DE)
(72) Erfinder: Schaadt, Dieter, 32457 Porta Westfalica (DE); Diekröger, Uwe, 32469 Petershagen (DE)
(74) Vertreter: Philipp, Matthias

(57) **Zusammenfassung**

Gehäuse mit einem geradlinig verlaufenden Kantenbereich (4) und einem Klemmelement (8), dass um eine parallel zu dem Kantenbereich (4) verlaufende Schwenkachse (10) schwenkbar gehalten ist, ein mit Abstand und parallel zu der Schwenkachse (10) angeordnetes Andruckelement (20) aufweist und durch ein Spannelement (26) in Richtung einer Klemmstellung schwenkbar ist, wobei eine abnehmbare Gehäusewand (6) zwischen einem sich von dem Kantenbereich (4) erstreckenden Anlagebereich (12) und dem Andruckelement (24) klemmend fixierbar ist.

## Beschreibung

Die Erfindung bezieht sich auf ein Gehäuse, das sich insbesondere zur Aufnahme von elektrischen oder elektronischen Komponenten oder Anzeigen eignet.

Um bei einem Gehäuse Einbau- und Wartungsarbeiten durchführen zu können, muss ein Deckel, ein Wandteil oder eine Seitenwand des Gehäuses geöffnet und anschließend wieder geschlossen werden, was üblicherweise mit dem Lösen und erneuten Festschrauben von zahlreichen Befestigungsschrauben verbunden ist. Dies ist sowohl in konstruktiver Hinsicht aufwendig als auch zeitintensiv.

Die Erfindung hat sich zur Aufgabe gestellt, ein Gehäuse dahingehend zu verbessern, dass der Öffnungs- und Schließvorgang einer Gehäusewand bzw. eines Wandteiles weniger Zeit in Anspruch nimmt und konstruktiv vereinfacht ist.

Diese Aufgabe wird erfindungsgemäß durch ein Gehäuse mit einem geradlinig verlaufenden Kantenbereich und einem Klemmelement gelöst, dass um eine parallel zu dem Kantenbereich verlaufende Schwenkachse schwenkbar gelagert ist, ein mit Abstand und parallel zu der Schwenkachse angeordnetes Andruckelement aufweist und durch ein Spannelement in Richtung einer Klemmstellung schwenkbar ist, wobei eine abnehmbare Gehäusewand zwischen einem sich von dem Kantenbereich erstreckenden Anlagebereich und dem Andruckelement klemmend fixierbar ist.

Hierbei kann vorgesehen sein, dass der Kantenbereich an eine obere, untere, Vorder-, Rück- und/oder Seitenwand des Gehäuses grenzt.

Die abnehmbare Gehäusewand kann eine obere, untere, Vorder-, Rück- oder Seitenwand oder ein Teil davon sein.

Die abnehmbare Gehäusewand kann von zwei, drei oder vier Klemmelementen gehalten sein.

Es kann vorteilhaft vorgesehen sein, dass die Schwenkachse mit Abstand von einer Erstreckungsebene oder den Erstreckungsebenen einer oder beider sich von dem Kantenbereich erstreckenden Gehäuserand oder Gehäusewänden angeordnet ist.

Das Klemmelement kann einen ersten Schenkel aufweisen, an dem das Andrückelement angeordnet ist, und einen davon abgewinkelten zweiten Schenkel, an dem die Schwenkachse angeordnet ist.

Das Spannmittel kann als Schraube, Feder, Spannhebel oder Ähnliches ausgebildet sein, wobei es vorteilhaft ist, wenn das Spannmittel als Klemmschraube ausgebildet ist und dem zwischen dem ersten oder zweiten Schenkel des Klemmelements und einer Gehäusewand wirkt. Dabei ist vorteilhaft, wenn die Klemmschraube mit dem zweiten Schenkel zusammen wirkt und von außen gegen eine Gehäusewand zustellbar ist.

Es kann vorgesehen sein, dass das Andruckelement elastisch ist. Das Anlageelement kann mit einem Dichtelement versehen sein.

In einer vorteilhaften Ausführungsform ist vorgesehen, dass der Kantenbereich aus stranggepresstem Material gebildet ist, etwa aus Kunststoff oder Aluminium. Weiter kann vorgesehen sein, dass das Klemmelement aus stranggepresstem Material gebildet ist.

Die Schwenkachse kann durch eine Profilverdickung mit kreisförmigem Querschnitt und einen damit zusammenwirkenden offenen kanalförmigen Profilbereich mit einem entsprechenden kreisförmigen freien Querschnitt gebildet sein.

Zwischen Klemmelement und Kantenbereich kann eine Aufstellfeder angeordnet sein, beispielsweise in Form einer Blattfeder.

Es kann vorgesehen sein, dass das Gehäuse mehrere mit Klemmelementen zu haltende abnehmbare Gehäusewände aufweist.

Die Erfindung wird nachfolgenden anhand eines Ausführungsbeispiels erläutert, wobei auf eine Zeichnung Bezug genommen ist, in der
Fig. 1 einen Teil einer Seitenwand eines Gehäuses mit einem Kantenbereich und einem geöffneten Klemmelement zeigt,
Fig. 2 eine Ansicht entsprechend Fig. 1 mit geschlossenem Klemmeelement zeigt,
Fig. 3, 4 weitere perspektivische Ansichten entsprechend Fig. 1 zeigen,
Fig. 5 und 5a eine stirnseitige Ansicht der Gehäusewand entsprechend Fig. 1 und eine vergrößerte Teilansicht des Kantenbereichs mit geöffnetem Klemmelement zeigen, und
Fig. 6 und 6a entsprechende Ansichten wie Fig. 5 und 5a mit geschlossenem Klemmelement zeigen.

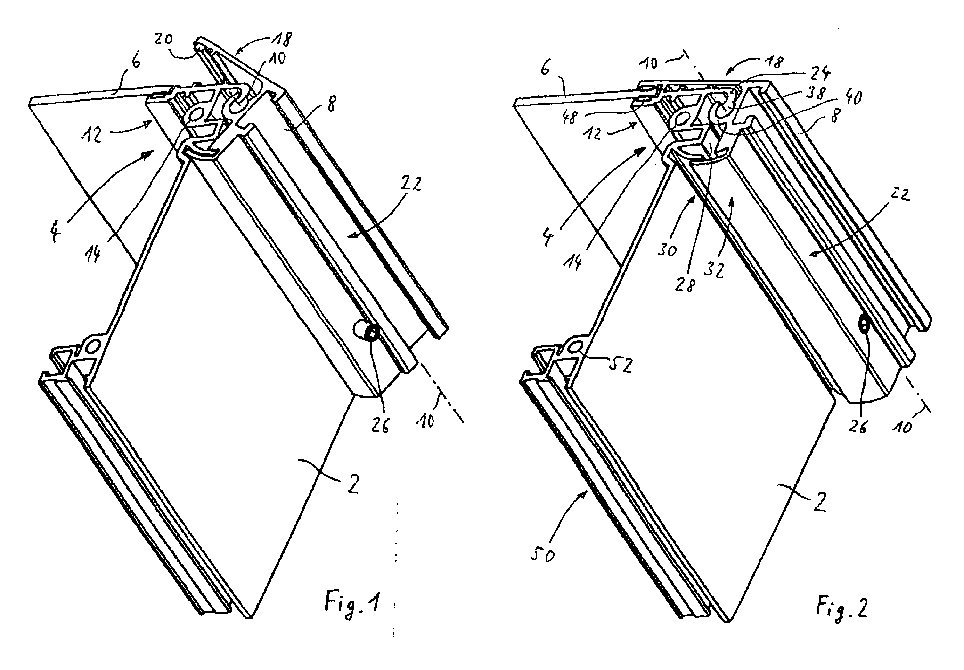

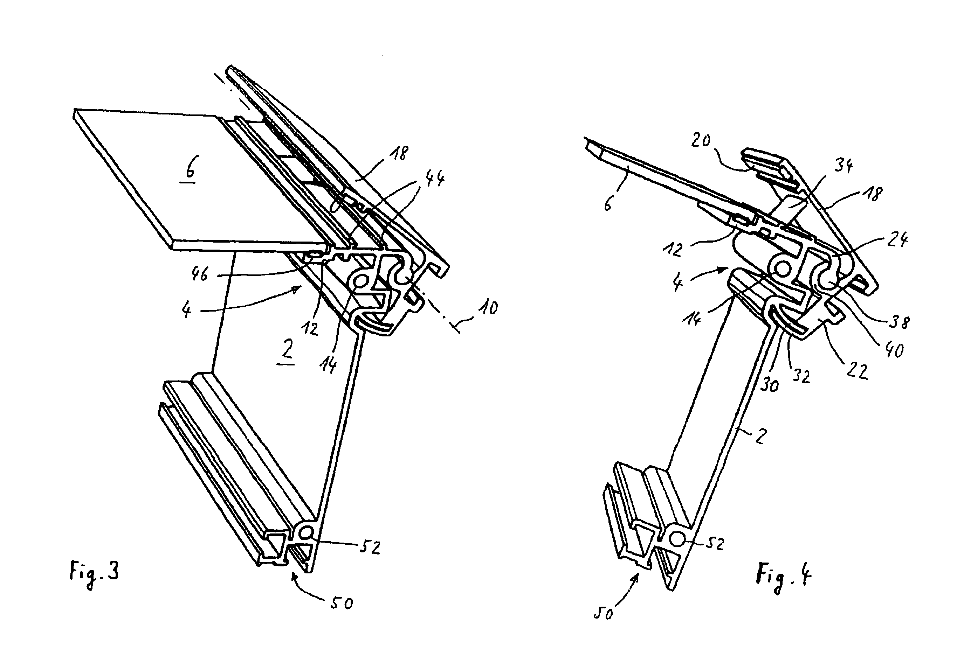

Fig. 1 bis 4 zeigen perspektivische Ansichten eines Gehäuseausschnitts in unterschiedlichen Blickrichtungen, wobei eine Seitenwand 2 und ein Kantenbereich 4 dargestellt sind. Der Kantenbereich 4 bildet einen in diesem Falle rechtwinkligen Übergang von der Seitenwand 2 zu einer Vorderseite des Gehäuses, die in dem dargestellten Beispiel im Wesentlichen durch eine Frontplatte 6 gebildet ist. Die Frontplatte 6 ist an dem Kantenbereich 4 mittels eines Klemmelements 8 lösbar gehalten. Das Klemmelement 8 ist um eine parallel zu dem Kantenbereich 4 verlaufende Schwenkachse 10 schwenkbar gehalten und zwischen einer geöffneten Stellung (Fig.1, 3 und 4) und einer geschlossenen Klemmstellung (Fig. 2) bewegbar. Der Kantenbereich 4 bildet im Wesentlichen den Übergang zwischen der Seitenwand 2 und der durch die Frontplatte 6 gebildeten Vorderseite oder Vorderwand und weist in dem dargestellten Beispiel angeformt die Schwenkachse 10 bzw. ein Element davon sowie einen Anlagebereich 12 auf, zwischen dem und dem Klemmelement 8 die Frontplatte 6 zu halten ist. Weiterhin ist der Kantenbereich 4 mit einem Schraubkanal 14 versehen, um weitere Seitenwände, Kantenelemente oder Ähnliches montieren zu können.

Das Klemmelement 8 weist einen ersten Schenkel 18 auf, an dem ein elastisches Andruckelement 20 gehalten ist, sowie einen zweiten Schenkel 22, der gemeinsam mit einem abgewinkelten Vorsprung 24 des Kantenbereichs 4 die Schwenkachse 10 bildet.

Das Klemmelement 8 ist mit mindestens einem Spannmittel versehen, das in dem dargestellten Beispiel durch einen eine Klemmschraube bildenden Gewindestift 26 realisiert ist, der in eine Gewindebohrung in dem zweiten Schenkel 22 eingreift und mit einer Anschlagfläche 28 zusammenwirkt, die am Rande des Kantenbereichs 4 in den Nähe zum Übergang zur Seitenwand 2 angeordnet ist. Die Anschlagfläche 28 ist mit Abstand zur Erstreckungsebene der Seitenwand 2 und in der Nähe der Schwenkachse 10 angeordnet.

In einem Übergangsbereich zwischen Kantenbereich 4 und Seitenwand 2 weisen sowohl der Kantenbereich 4 als auch das Klemmelement 8 ein radial um die Schwenkachse 10 Verläufen des Wandstück 30, 32 auf, wobei sich die Wandstücke mit geringem radialen Abstand voneinander befinden und eine Abdeckfunktion bzgl. des Zwischenraums zwischen Kantenbereich 4 und zweitem Schenkel 22 des Klemmelements und somit auch der Schwenkachse 10, des Gewindestifts 26 und der Anschlagfläche 28 nach außen hin haben.

Eine Blattfeder 34 ist an dem Kantenbereich 4 gehalten und wirkt zwischen diesem und dem ersten Schenkel 18 des Klemmelements 8 in Öffnungsrichtung, so dass das Klemmelement 8 mit Hilfe des Gewindestifts 26 gegen die Federkraft der Blattfeder in die geschlossenen Stellung oder Klemmstellung nach Fig. 2 gebracht werden kann.

Im dargestellten Ausführungsbeispiel sind die Seitenwand 2 und der Kantenbereich 4 einstückig als Strangpressteil aus Kunststoff oder Leichtmetall hergestellt, und auch das Klemmelement 8 ist aus einem vergleichbaren Material als Strangpressteil hergestellt. Dies hat fertigungstechnisch den Vorteil, dass die Schwenkachse 10 in einfacher Weise durch eine Profilverdickung 38 mit kreisförmigen Querschnitt, die an einem abgewinkelten Wandstück 40 sitzt, und einen offenen, kanalförmigen Profilbereich 42 mit einem entsprechenden kreisförmigen freien Querschnitt gebildet werden kann. Auch der Schraubkanal 14 sowie die aus der Erstreckungsebene der Seitenwand 2 verlagerte Anschlagfläche 28 können in einfacher Weise durch entsprechende Gestaltung des Wandverlaufs geformt werden. Die Blattfeder 34 ist hinter zwei hakenförmigen Profilvorsprüngen 44 gehalten. Der Anlagebereich 12 ist ebenfalls einstückig mit dem Kantenbereich 4 ausgebildet und weist eine kanalförmige Vertiefung 46 zur Aufnahme eines elastischen Dichtelements 48 auf.

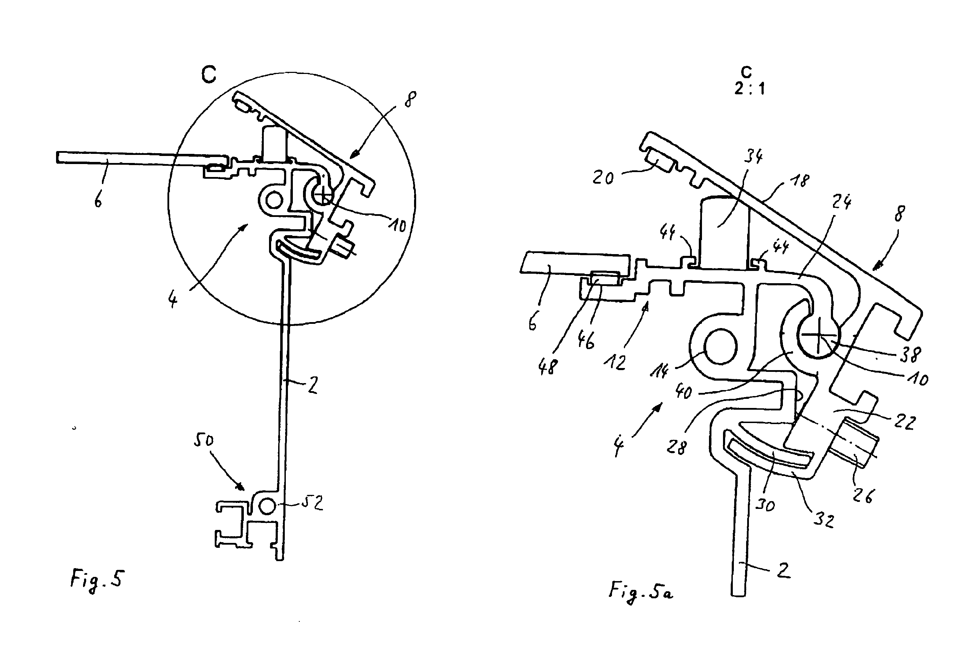

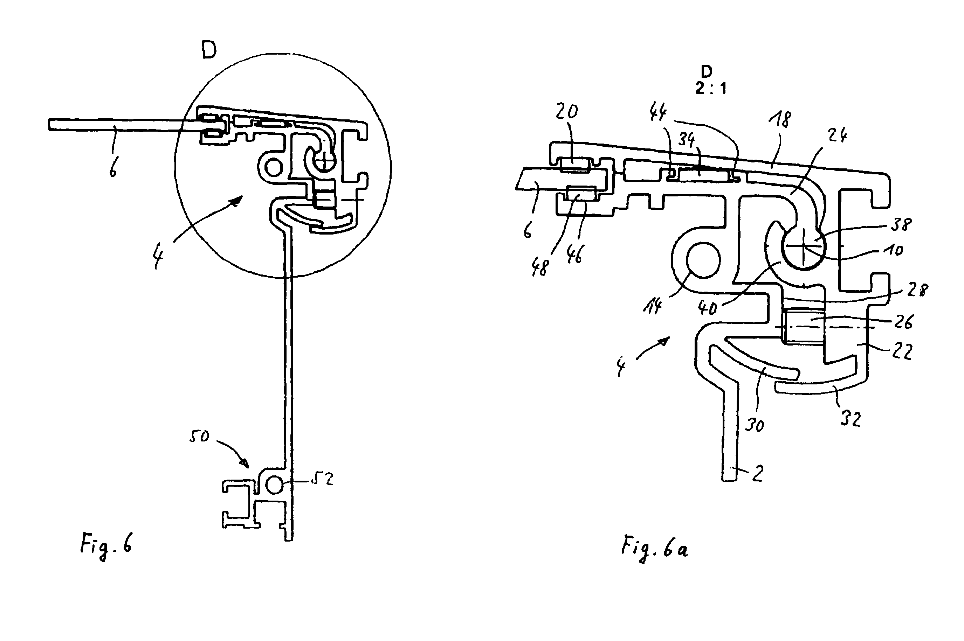

Stirnseitige, die Querschnittsprofile von Seitenwand 2, Kantenbereich 4 und Klemmelement 8 zeigende Ansichten nach Fig. 5 und 6 und insbesondere die Detailansichten nach Fig. 5a, 6a zeigen weitere Einzelheiten der Erfindung in offener und geschlossener Stellung des Klemmelements 8. Weitere, nicht dargestellte Seitenwände des Gehäuses können sich senkrecht zu der Seitenwand 2 und senkrecht zur Schwenkachse 10 anschließen, wobei der bereits genannte Schraubkanal 14 sowie ein weiterer, in einem dem Kantenbereich 4 gegenüberliegenden Kantenbereich 50 angeordneter Schraubkanal 52 zur Verschraubung dienen können. Eine weitere Gehäusewand, beispielsweise eine Rückwand, kann sich parallel zur Frontplatte 6 an den weiteren Kantenbereich 50 anschließen.

Aufgrund der Herstellung des Klemmelements 8 und des Kantenbereichs 4 oder der kompletten Seitenwand 2 als Strangpressprofil kann das Klemmelement 8, nachdem es auf die benötigte Länge angelängt worden ist, entlang der Schwenkachse 10 auf die Profilverdickung 38 des Kantenbereichs aufgeschoben werden und ist nach einer geeigneten seitlichen Fixierung, bespielsweise durch Kantenelemente oder Seitenteile, unlösbar an der Seitenwand 2 gehalten.

Durch Drehung des Gewindestiftes 26 in der einen oder anderen Richtung kann das Klemmelement 8 zunächst durch die Kraft der Blattfeder 34 in die geöffnete Stellung gebracht werden, in der die Frontplatte 6 eingelegt werden kann, und anschließend in die geschlossene oder Klemmestellung nach Fig.2 oder 6, in der das Klemmelement die Frontplatte zwischen seinem ersten Schenkel 18 und dem Anlagebereich 12 des Kantenbereichs 4 festklemmt. Wenn Kantenbereich und Klemmelement aus Aluminium hergestellt sind, weisen sie eine hohe Festigkeit und Steifigkeit auf, so dass ein einziger Gewindestift 26 bei nicht zu großen Gehäusebreiten genügt. Durch Anordnung eines entlang eines Umfangrands der Frontplatte 6 umlaufenden Dichtelements 48 kann eine wasser- und staubdichte Fixierung der Frontplatte 6 erzielt werden.

Obwohl in dem vorstehend beschriebenen Ausführungsbeispiel die Schwenkachse 10 einstückig an dem Kantenbereich 4 angeformt ist, kann vorgesehen sein, dass die Schwenkachse lösbar bzgl. des Kantenbereichs 4 ist und beispielsweise mittels Befestigungsschrauben daran befestigt ist.

Während ein einziges Klemmelement 8 zur sicheren Fixierung einer Gehäusewand wie etwa der Frontplatte 6 ausreicht, insbesondere wenn diese beispielsweise an einem gegenüberliegenden Rand hinter einen Haltevorsprung formschlüssig eingelegt ist, kann vorgesehen sein, dass eine Gehäusewand von mehreren Klemmelementen gehalten ist, beispielsweise zwei, drei oder vier Klemmelementen.

### Bezugszeichenliste

- 2: Seitenwand
- 4: Kantenbereich
- 6: Frontplatte
- 8: Klemmelement
- 10: Schwenkachse
- 12: Anlagebereich
- 14: Schraubkanal
- 18: erster Schenkel
- 20: Andruckelement
- 22: zweiter Schenkel
- 24: Vorsprung
- 26: Gewindestift
- 28: Anschlagfläche
- 30, 32: Wandstück
- 34: Blattfeder
- 38: Profilverdickung
- 40: kanalförmiger Profilbereich
- 44: Profilvorsprung
- 46: Vertiefung
- 48: Dichtelement
- 50: weiterer Kantenbereich
- 52: Schraubkanal

## Patentansprüche

1. Gehäuse mit einem geradlinig verlaufenden Kantenbereich (4) und einem Klemmelement (8), dass um eine parallel zu dem Kantenbereich (4) verlaufende Schwenkachse (10) schwenkbar gehalten ist, ein mit Abstand und parallel zu der Schwenkachse (10) angeordnetes Andruckelement (20) aufweist und durch ein Spannelement (26) in Richtung einer Klemmstellung schwenkbar ist, wobei eine abnehmbare Gehäusewand (6) zwischen einem sich von dem Kantenbereich (4) erstreckenden Anlagebereich (12) und dem Andruckelement (24) klemmend fixierbar ist.

2. Gehäuse nach Anspruch 1, **dadurch gekennzeichnet, dass** der Kantenbereich (4) an eine obere, untere, Vorder-, Rück- und/oder Seitenwand (2) des Gehäuses grenzt.

3. Gehäuse nach Anspruch 2, **dadurch gekennzeichnet, dass** die abnehmbare Gehäusewand (6) eine obere, untere, Vorder- (6), Rück- oder Seitenwand oder ein Teil davon ist.

4. Gehäuse nach einem vorangehenden Ansprüchen, **dadurch gekennzeichnet, dass** die abnehmbare Gehäusewand (6) von zwei, drei oder vier Klemmelementen gehalten ist.

5. Gehäuse nach einem der vorangehenden Ansprüche, **dadurch gekennzeichnet, dass** die Schwenkachse (10) mit Abstand von einer Erstreckungsebene oder den Erstreckungsebenen einer oder beider sich von dem Kantenbereich (4) erstreckenden Gehäusewand oder Gehäusewänden (2, 6) angeordnet ist.

6. Gehäuse nach einem der vorangehenden Ansprüche, **dadurch gekennzeichnet, dass** das Klemmelement (8) einen ersten Schenkel (18) aufweist, an dem das Andruckelement (20) angeordnet ist, und einen davon abgewinkelten zweiten Schenkel (22), an dem die Schwenkachse (10) angeordnet ist.

7. Gehäuse nach Anspruch 6, **dadurch gekennzeichnet, dass** das Spannmittel als Klemmschraube (26) ausgebildet ist und zwischen dem ersten (18) oder zweiten (22) Schenkel des Klemmelements (8) und einer Gehäusewand (2) wirkt.

8. Gehäuse nach Anspruch 7, **dadurch gekennzeichnet, dass** die Klemmschraube (26) mit dem zweiten Schenkel (22) zusammenwirkt und von außen gegen eine Gehäusewand (2) zustellbar ist.

9. Gehäuse nach einem der vorangehenden Ansprüche, **dadurch gekennzeichnet, dass** Andruckelement (24) elastisch ist.

10. Gehäuse nach einem der vorangehenden Ansprüche, **dadurch gekennzeichnet, dass** der Anlagebereich (12) mit einem Dichtelement (48) versehen ist.

11. Gehäuse nach einem der vorangehenden Ansprüche, **dadurch gekennzeichnet, dass** der Kantenbereich (4) aus einem stranggepressten Material gebildet ist.

12. Gehäuse nach einem der vorangehenden Ansprüche, **dadurch gekennzeichnet, dass** das Klemmelement (8) aus einem stranggepressten Material gebildet ist.

13. Gehäuse nach einem der vorangehenden Ansprüche, **dadurch gekennzeichnet, dass** die Schwenkachse (10) durch eine Profilverdickung (38) mit kreisförmigen Querschnitt und einem offenen kanalförmigen Profilbereich (40) mit einem entsprechenden kreisförmigen freien Querschnitt gebildet ist.

14. Gehäuse nach einem der vorangehenden Ansprüche, **dadurch gekennzeichnet, dass** zwischen Klemmelement (8) und Kantenbereich (4) eine Aufstellfeder (34) angeordnet ist.

15. Gehäuse nach einem der vorangehenden Ansprüche, **dadurch gekennzeichnet, dass** das Gehäuse mehrere mit Klemmelementen zu haltende abnehmbare Gehäusewände aufweist.
